# EUROPEAN PATENT APPLICATION

(11) **EP 2 270 882 A1**
(43) Date of publication of application: **05.01.2011**
(21) Application number: 09164117.5
(22) Date of filing: 30.06.2009
(51) Int. Cl.: H01L 33/00

(54) **Light emitting diode circuit for ambient light**

(71) Applicant: Koninklijke Philips Electronics N.V., 5621 BA Eindhoven (NL)
(72) Inventor: The designation of the inventor has not yet been filed
(74) Representative: Damen, Daniel Martijn

(57) **Abstract**

A light emitting diode circuit (10) comprises a die with a light emitting diode for providing first ambient light (11) originating from a top side of the die and for providing second ambient light (12) originating from a bottom side of the die, to avoid complex and color dependent reflecting surfaces and to use the light more efficiently. The die may be placed on a substrate, planes of the die and the substrate being non-parallel planes, and the die may be at least partly surrounded by an at least partly transparent housing. A device (1) comprises the light emitting diode circuit (10) and a display / screen (2) supported by the first ambient light (11) having a first function like a support at a left / right / rear side of the device (1) and supported by the second ambient light (12) having a second function like a support at a left / right / front side of the device (1).

## Description

### FIELD OF THE INVENTION

The invention relates to a light emitting diode circuit comprising a die with a light emitting diode for providing ambient light. The invention also relates to a device comprising such a light emitting diode circuit, and to a method for providing ambient light.

Examples of such a device are television receivers and monitors.

### BACKGROUND OF THE INVENTION

US 7,414,270 discloses a side-emitting light emitting diode package, wherein a top-emitting light emitting diode chip emits light through its top surface. A bottom surface of the light emitting diode chip is mounted on a substrate via a sub-mount. Planes of the top surface and the bottom surface are located in parallel to planes of the sub-mount and the substrate. A reflecting surface inside the light emitting diode package reflects the light in such a way that the reflected light leaves the light emitting diode package sideways. This way, a side-emitting light emitting diode package has been created.

When using differently colored light emitting diodes simultaneously, per differently colored light emitting diode, a different reflecting surface will be required, owing to the fact that a reflection at a reflecting surface will depend upon a wavelength. In other words, a reflection at a reflecting surface will be color dependent.

### SUMMARY OF THE INVENTION

It is an object of the invention to provide an improved light emitting diode circuit, wherein a top-emitting light emitting diode is used to create a multi-side-emitting light emitting diode circuit, wherein reflection plays a relatively unimportant role. Further objects are to provide an improved device and an improved method.

According to a first aspect of the invention, a light emitting diode circuit is defined comprising a die with a light emitting diode for providing first and second ambient light, the first ambient light originating from a top side of the die and the second ambient light originating from a bottom side of the die.

The invention uses a light emitting diode that emits light from its top surface and that emits light from its bottom surface. When using the light emitted from the top side of the die as first ambient light and when using the light emitted from the bottom side of the die as second ambient light, the reflecting surface from US 7,414,270 can be avoided. As a result, a multi-side-emitting light emitting diode circuit has been created, wherein reflection plays, compared to the side-emitting light emitting diode package from US 7,414,270, an at least less important role. Compared to the side-emitting light emitting diode package from US 7,414,270, that fully ignores the light that is leaving the light emitting diode from its bottom surface, the invention uses a light emitting diode more efficiently.

The fact that the light emitting diode emits light from its top surface and emits light from its bottom surface does not exclude a possibility that the light emitting diode might further emit light from one or more of its side surfaces. A light emitting diode that emits main light from its top surface at one side of a die and that emits further light from its bottom surface at another side of the die is generally called a "top-emitting" light emitting diode. A die is also known as naked chip or housing-less chip.

According to an embodiment, the light emitting diode circuit is defined by the first ambient light being of a higher intensity than the second ambient light. Usually, the light emitted from the top side of the die (the top surface of the light emitting diode) will have a higher intensity than the light emitted from the bottom side of the die (the bottom surface of the light emitting diode).

According to an embodiment, the light emitting diode circuit is defined by the first ambient light being provided in first directions and the second ambient light being provided in second directions. Usually, the light emitted from the top side will be emitted in other directions than the light emitted from the bottom side.

According to an embodiment, the light emitting diode circuit is defined by at least one of the first directions and at least one of the second directions being opposite directions. Preferably, the light emitting diode circuit will show, when used as a stand-alone, a kind of omni-directional radiation pattern.

According to an embodiment, the light emitting diode circuit is defined by at least one of the directions being perpendicular to the die. Again, preferably, the light emitting diode circuit will show, when used as a stand-alone, a kind of omni-directional radiation pattern.

According to an embodiment, the light emitting diode circuit is defined by the die being placed on a substrate, a plane of the die and a plane of the substrate being substantially perpendicular planes. Contrary to the side-emitting light emitting diode package from US 7,414,270, wherein planes of the top surface and the bottom surface and planes of the sub-mount and the substrate are all parallel planes, in the light emitting diode circuit the die has been turned, between 45 and 135 degrees, preferably between 60 and 120 degrees, further preferably between 80 and 100 degrees, most preferably for about 90 degrees. Therefore, substantially perpendicular here corresponds with an angle between 45 and 135 degrees, preferably between 60 and 120 degrees, further preferably between 80 and 100 degrees, most preferably for about 90 degrees. Such a turned light emitting diode circuit is advantageous in that a size of the combination of the light emitting diode circuit and the substrate in at least one direction is reduced.

According to an embodiment, the light emitting diode circuit is defined by the die being at least partly surrounded by an at least partly transparent housing. Such a transparent housing is advantageous in that it can be relatively thin, whereby a size of the combination of the light emitting diode circuit and the housing is reduced. An at least partly transparent housing is a housing that as a whole is at least partly transparent or that comprises parts, one or more parts being more transparent than one or more other parts. These one or more other parts are each then less transparent or not transparent at all. The housing might have any kind of shape.

According to an embodiment, the light emitting diode circuit is defined by further comprising a further die with a further light emitting diode for providing further first and further second ambient light, the further first ambient light originating from a top side of the further die and the further second ambient light originating from a bottom side of the further die.

According to an embodiment, the light emitting diode circuit is defined by further comprising a yet further die with a yet further light emitting diode for providing yet further first and yet further second ambient light, the yet further first ambient light originating from a top side of the yet further die and the yet further second ambient light originating from a bottom side of the yet further die.

According to an embodiment, the light emitting diode circuit is defined by the first and second ambient light being of a first color, the further first and further second ambient light being of a second color and the yet further first and yet further second ambient light being of a third color. Preferably, the first, second and third colors are different colors, such as for example red, green and blue.

According to a second aspect of the invention, a device is defined comprising the light emitting diode circuit as defined above, the device further comprising a display /screen supported by the first and second ambient light. The ambient light supports the display / screen by increasing a surface / environment that provides information to a viewer.

Ambilight, which is short for Ambient Lighting Technology, is a feature invented by Philips Electronics in The Netherlands for generating light effects around a display / screen, which light effects correspond to the video content shown via the display /screen. These generated light effects are for example a larger virtual display / screen, a more immersive viewing experience, a reduction of viewer eye strain, and a reduction of a visibility of a typical liquid crystal display problem (backlight bleed, where black is turned into grey) etc.

According to an embodiment, the device is defined by the first ambient light having a first function and the second ambient light having a second function. Usually, the first and second functions will be at least partly different functions. A first (second) function for example comprises supporting a display / screen with light at a first (second) location and/or with light having a first (second) intensity and/or with light having a first (second) direction and/or with light having a first (second) shape and/or with light that has been filtered in a first (second) manner etc.

According to an embodiment, the device is defined by the first function comprising a support at a left/right side or a rear side of the device and the second function comprising a support at a left/right side or a front side of the device. So, the first function comprises a support of the display / screen at a left / right / rear side of the device and the second function comprises a support of the display / screen at a left / right / front side of the device. At the moment, without excluding future changes, the first ambient light may usually be used for generating light effects behind the device and at (rear) parts of sides of the device, and the second ambient light may usually be used for mainly generating light effects at a front of the device and could be used for auxiliary generating light effects at front parts of sides of the device etc.

According to a third aspect of the invention, a method for providing first and second ambient light is defined by the method comprising a step of using a light emitting diode circuit comprising a die with a light emitting diode, the first ambient light originating from a top side of the die and the second ambient light originating from a bottom side of the die.

Embodiments of the device and of the method correspond with the embodiments of the light emitting diode circuit.

US 7,254,309 discloses a side-emitting light emitting diode and lens having a disadvantageous complex structure and ignoring the light leaving the light emitting diode from its bottom surface.

US 6,908,219 discloses an optical element for a high mounted stop lamp with a light emitting diode light source having a disadvantageous complex structure and ignoring the light leaving the light emitting diode from its bottom surface.

An insight might be that (certain) light emitting diodes emit light through their top surfaces as well as through their bottom surfaces.

A basic idea might be that first ambient light may originate from a top side of a die and second ambient light may originate from a bottom side of the die.

A problem to provide an improved light emitting diode circuit, wherein a top-emitting light emitting diode is used to create a multi-side-emitting light emitting diode circuit, wherein reflection plays a relatively unimportant role, has been solved.

A further advantage might be that (light from) a light emitting diode is used more efficiently, that complex and/or color dependent reflection surfaces can be avoided, that a number of reflectors and/or diffusers can be reduced, that a complexity of reflectors and/or diffusers can be reduced, that sizes and locations of the light emitting diode circuit and reflectors and/or diffusers can become less critical, that costs of a production process of a light emitting diode circuit and/or a device are reduced, and that a size of a combination of a light emitting diode circuit on the one hand and a substrate and/or a housing on the other hand is reduced.

In addition, another application of the light emitting diode circuit might be a light emitting diode based backlight.

These and other aspects of the invention are apparent from and will be elucidated with reference to the embodiment(s) described hereinafter.

### BRIEF DESCRIPTION OF THE DRAWINGS

In the drawings:
Fig. 1 shows a prior art device with a prior art light emitting diode circuit, and
Fig. 2 shows a device according to the invention with a light emitting diode circuit according to the invention.

### DETAILED DESCRIPTION OF EMBODIMENTS

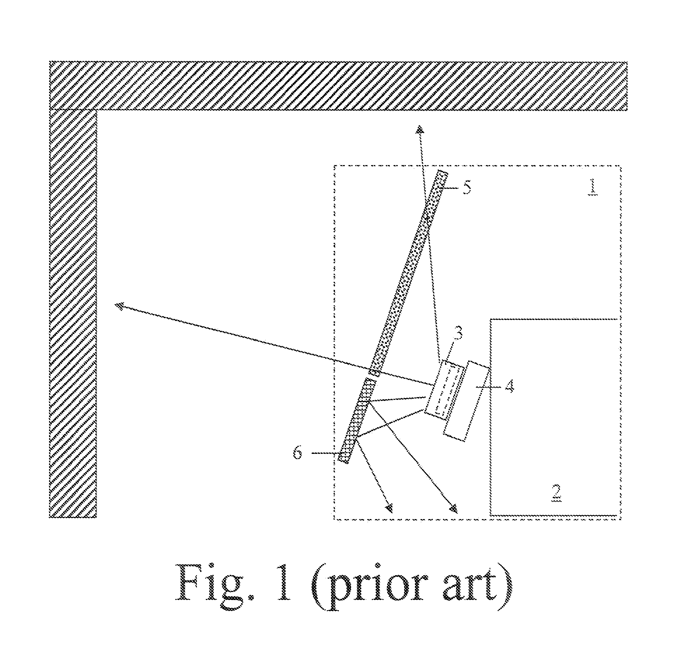

In the Fig. 1, a prior art device 1 with a prior art light emitting diode circuit 3 is shown (top view). The device 1 further comprises a display / screen 2 and a substrate 4 on which the light emitting diode circuit 3 has been mounted. The light emitting diode circuit 3 comprises a die, indicated by the dashed block inside the light emitting diode circuit 3, with a light emitting diode. The light emitting diode emits light from its top surface, in other words the die emits light from its top side. Any light emitted by the light emitting diode from its bottom surface, in other words any light emitted by the die from its bottom side, enters the substrate 4 and is lost.

Some light coming from the light emitting diode circuit 3 will pass a diffuser 5 and reach the left wall and/or the rear wall and produce a halo (or more than one), and other light coming from the light emitting diode circuit 3 will be reflected by a reflector 6 and then go to a front side of the device 1. This way, in the past, ambient light has been produced by using only a top surface of a light emitting diode and/or by using only a top side of a die.

In this prior art situation, an angle between the light emitting diode circuit 3 and a part of the device 1 and/or the display / screen 2 is relatively crucial, an angle between the diffuser 5 and a part of the device 1 and/or the display / screen 2 is relatively crucial, and an angle between the reflector 6 and a part of the device 1 and/or the display / screen 2 is relatively crucial. Here, all angles shown are about the same, but in a real situation, the angles may need to get different values. The diffuser 5 and/or the reflector 6 may need to get complex properties and may need to be at least partly bended. More complex elements will usually need to be present. Finally, some light from the light emitting diode is not used at all.

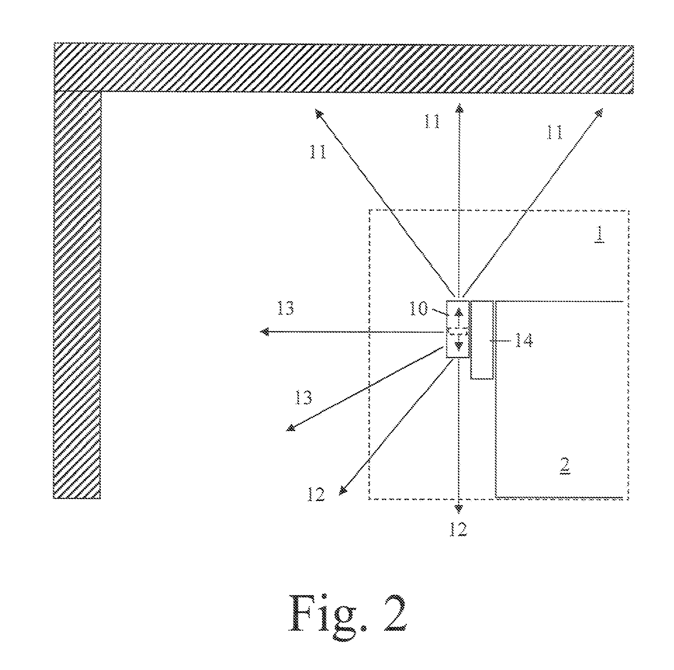

In the Fig. 2, a device 1 according to the invention with a light emitting diode circuit 10 according to the invention is shown (top view). The device 1 further comprises a display / screen 2 and a substrate 14 on which the light emitting diode circuit 10 has been mounted. The light emitting diode circuit 10 comprises a die, indicated by the dashed block inside the light emitting diode circuit 10, with a light emitting diode. The light emitting diode emits light from its top surface, in other words the die emits first ambient light 11 from its top side. The light emitting diode also emits light from its bottom surface, in other words the die also emits second ambient light 12 from its bottom side. Further, third ambient light 13 may be emitted from a "sideways" side of the die.

As a result, a multi-side-emitting light emitting diode circuit has been created, wherein a light emitting diode is used more efficiently. Contrary to the prior art situation shown in the Fig. 1, wherein planes of the die and the substrate are parallel planes, in the light emitting diode circuit 10 the plane of the die is not parallel to the plane of the substrate 14. In the light emitting diode circuit 10, the die has been turned, for example between 45 and 135 degrees, preferably between 60 and 120 degrees, further preferably between 80 and 100 degrees, most preferably for about 90 degrees. Such a turned light emitting diode circuit 10 is advantageous in that a size of the combination of the light emitting diode circuit 10 and the substrate 14 in at least one direction is reduced. The die may be at least partly surrounded by an at least partly transparent housing. Such a transparent housing is advantageous in that it can be relatively thin owing to the fact that it does not need to block light but it should on the contrary let the light pass. Such a transparent and thin housing is advantageous in that a size of the combination of the light emitting diode circuit and the housing is reduced. The light emitting diode circuit 10 produces a highly advantageous radiation pattern of about 270 degrees, when located as shown in the Fig. 2, without thereby requiring relatively many and/or relatively complex structures.

Preferably and/or usually, the light emitting diode circuit 10 may comprise a die per color, each die comprising one or more light emitting diodes of the same color, or may comprise one or more dies, each die comprising one or more light emitting diodes of two or more colors etc.

In case an intensity of the second ambient light 12 is too low, a part of the first ambient light 11 may be partly reflected to support the second ambient light 12 etc. So, one or more reflectors may still need to be present and are not to be excluded. Similarly, one or more diffusers may still need to be present and are not to be excluded. Other locations of the light emitting diode circuit 10 in relation to the device 1 are not to be excluded too.

Summarizing, a light emitting diode circuit 10 comprises a die with a light emitting diode for providing first ambient light 11 originating from a top side of the die and for providing second ambient light 12 originating from a bottom side of the die, to avoid complex and color dependent reflecting surfaces and to use the light more efficiently. The die may be placed on a substrate, planes of the die and the substrate being non-parallel planes, and the die may be at least partly surrounded by an at least partly transparent housing. A device 1 comprises the light emitting diode circuit 10 and a display / screen 2 supported by the first ambient light 11 having a first function like a support at a left / right / rear side of the device 1 and supported by the second ambient light 12 having a second function like a support at a left / right / front side of the device 1.

While the invention has been illustrated and described in detail in the drawings and foregoing description, such illustration and description are to be considered illustrative or exemplary and not restrictive; the invention is not limited to the disclosed embodiments. For example, it is possible to operate the invention in an embodiment wherein different parts of the different disclosed embodiments are combined into a new embodiment.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored / distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. A light emitting diode circuit (10) comprising a die with a light emitting diode for providing first and second ambient light (11, 12), the first ambient light (11) originating from a top side of the die and the second ambient light (12) originating from a bottom side of the die.

2. The light emitting diode circuit (10) as claimed in claim 1, the first ambient light (11) being of a higher intensity than the second ambient light (12).

3. The light emitting diode circuit (10) as claimed in claim 1, the first ambient light (11) being provided in first directions and the second ambient light (12) being provided in second directions.

4. The light emitting diode circuit (10) as claimed in claim 3, at least one of the first directions and at least one of the second directions being opposite directions.

5. The light emitting diode circuit (10) as claimed in claim 3, at least one of the directions being perpendicular to the die.

6. The light emitting diode circuit (10) as claimed in claim 1, the die being placed on a substrate (14), a plane of the die and a plane of the substrate (14) being substantially perpendicular planes.

7. The light emitting diode circuit (10) as claimed in claim 1, the die being at least partly surrounded by an at least partly transparent housing.

8. The light emitting diode circuit (10) as claimed in claim 1, further comprising a further die with a further light emitting diode for providing further first and further second ambient light, the further first ambient light originating from a top side of the further die and the further second ambient light originating from a bottom side of the further die.

9. The light emitting diode circuit (10) as claimed in claim 8, further comprising a yet further die with a yet further light emitting diode for providing yet further first and yet further second ambient light, the yet further first ambient light originating from a top side of the yet further die and the yet further second ambient light originating from a bottom side of the yet further die.

10. The light emitting diode circuit (10) as claimed in claim 9, the first and second ambient light being of a first color, the further first and further second ambient light being of a second color and the yet further first and yet further second ambient light being of a third color.

11. A device (1) comprising the light emitting diode circuit (10) as claimed in claim 1, the device further comprising a display / screen (2) supported by the first and second ambient light (11, 12).

12. The device (1) as claimed in claim 11, the first ambient light (11) having a first function and the second ambient light (12) having a second function.

13. The device (1) as claimed in claim 12, the first function comprising a support at a left/right side or a rear side of the device (1) and the second function comprising a support at a left/right side or a front side of the device (1).

14. A method for providing first and second ambient light (11, 12), the method comprising a step of using a light emitting diode circuit comprising a die with a light emitting diode, the first ambient light (11) originating from a top side of the die and the second ambient light (12) originating from a bottom side of the die.
